# EUROPÄISCHE PATENTSCHRIFT

(11) **EP 3 532 857 B1**
(45) Veröffentlichungstag und Bekanntmachung des Hinweises auf die Patenterteilung: **25.01.2023**
(21) Anmeldenummer: 17778283.6
(22) Anmeldetag: 04.10.2017
(51) Int. Cl.: G01R 35/00, G01R 31/28

(54) **VORRICHTUNG UND VERFAHREN ZUR DIAGNOSE DER ERFASSUNG EINES MEHRPHASIGEN ELEKTRISCHEN STROMS**
DEVICE AND METHOD FOR DIAGNOSING THE DETECTION OF A MULTI-PHASE ELECTRIC CURRENT
DISPOSITIF ET PROCÉDÉ POUR LE DIAGNOSTIC DE LA DÉTECTION D'UN COURANT ÉLECTRIQUE POLYPHASÉ

(30) Priorität: 25.10.2016 DE 102016220948
(43) Veröffentlichungstag der Anmeldung: 04.09.2019
(73) Patentinhaber: Robert Bosch GmbH, 70442 Stuttgart (DE)
(72) Erfinder: SCHLESER, Roland, 74232 Abstatt (DE); HANEL, Stephan, 71706 Markgroeningen (DE)
(86) Internationale Anmeldenummer: PCT/EP2017/075140
(87) Internationale Veröffentlichungsnummer: WO 2018/077582

(56) Entgegenhaltungen:
- CH-A2- 708 761
- US-A1- 2013 057 307
- US-A1- 2014 159 756
- US-A1- 2015 015 235
- US-A1- 2015 185 279

## Beschreibung

Die vorliegende Erfindung betrifft eine Vorrichtung zur Diagnose einer Erfassung eines mehrphasigen elektrischen Stroms sowie ein Verfahren zur Diagnose von Sensorsignalen eines erfassten mehrphasigen elektrischen Stroms.

### Stand der Technik

Für die Regelung von elektrischen Maschinen in elektrischen Antriebssystemen werden die Phasenströme der elektrischen Maschine eingestellt. Hierzu sind kontinuierlich eine Erfassung der Phasenströme sowie eine nachfolgende Regelung dieser Phasenströme für das Einstellen eines vorgegebenen Sollmoments erforderlich. Fehler in der Erfassung der elektrischen Phasenströme können zu einer ungewollten Beschleunigung oder Verzögerung der elektrischen Maschine führen. Daher muss die Plausibilität der erfassten Phasenströme verifiziert werden.

Die Druckschrift US 2015/015235 A1 offenbart eine Strommesseinrichtung für einen Spannungswandler, wobei je Phase zwei Messpfade vorgesehen sind. Die Druckschrift US 2014/159756 A1 offenbart eine Diagnoseeinrichtung für eine Strommesseinrichtung zur Messung der Phasenströme einer elektrischen Maschine. Die Druckschrift US 2013/0057307 A1 offenbart einen Leistungsschalter zum Prüfen eines Rogowskiwandlers auf Drahtbruch. Die Druckschrift CH 708 761 A2 offenbart eine Messbrückenanordnung mit verbesserter Fehlererkennung. Die Druckschrift US 2015/185279 A1 offenbart eine Strommesseinrichtung mit einer Diagnoseeinrichtung.

Die Druckschrift DE 10 2012 217 116 A1 offenbart ein Verfahren zur Ermittlung der Phasenströme einer elektrischen Maschine mit einem Stromrichter. Dabei wird insbesondere vorgeschlagen, nicht die Ströme in allen elektrischen Phasen messtechnisch zu erfassen, sondern die Phasenströme einiger Phasen rechnerisch zu ermitteln.

### Offenbarung der Erfindung

Die vorliegende Erfindung offenbart eine Vorrichtung zur Diagnose einer Erfassung eines mehrphasigen elektrischen Stroms gemäß Patentanspruch 1 und ein Verfahren zur Diagnose von Sensorsignalen eines erfassten mehrphasigen elektrischen Stroms mit den Merkmalen des Patentanspruchs 8.

Demgemäß ist vorgesehen:
Eine Vorrichtung zur Diagnose einer Erfassung eines mehrphasigen elektrischen Stroms mit einem Stromsensor, einer Messeinrichtung, einer Prüfeinrichtung und einer Kontrolleinrichtung. Bei dem mehrphasigen elektrischen Strom kann es sich beispielsweise um einen elektrischen Strom mit mindestens drei oder gegebenenfalls auch mehr Phasen handeln. Der Stromsensor ist dazu ausgelegt, elektrische Phasenströme in den Phasen des zu erfassenden mehrphasigen elektrischen Stroms zu messen. Hierbei können die elektrischen Ströme in allen Phasen des mehrphasigen elektrischen Stroms gemessen werden. Ferner ist der Stromsensor dazu ausgelegt, zu jedem gemessenen Phasenstrom ein korrespondierendes Sensorsignal bereitzustellen. Die korrespondierenden Sensorsignale werden dabei an Ausgangsanschlüssen des Stromsensors bereitgestellt. Die Messeinrichtung umfasst mehrere Eingangsanschlüsse, wobei jeweils ein Eingangsanschluss mit einem Ausgangsanschluss des Stromsensors elektrisch gekoppelt ist. Die Messeinrichtung ist dazu ausgelegt, an den Eingangsanschlüssen bereitgestellte Signale zu erfassen. Die erfassten Signale an den Eingangsanschlüssen der Messeinrichtung können von der Messeinrichtung ausgewertet werden. Daraufhin kann die Messeinrichtung Ausgangssignale in analoger oder digitaler Form bereitstellen, die zu den erfassten Signalen an den Eingangsanschlüssen korrespondieren. Die Prüfeinrichtung ist mit mindestens einem ersten Eingangsanschluss der Eingangsanschlüsse der Messeinrichtung elektrisch gekoppelt. Die Prüfeinrichtung ist dabei dazu ausgelegt, den ersten Eingangsanschluss der Messeinrichtung für eine vorbestimmte Zeitspanne mit einem vorgegebenen Spannungspotential zu koppeln. Die Koppelung des Eingangsanschlusses mit dem vorgegebenen Spannungspotential kann dabei insbesondere über einen ohmschen Widerstand oder eine Impedanz erfolgen. Die Kontrolleinrichtung ist dazu ausgelegt, eine Fehlfunktion der Erfassung des mehrphasigen elektrischen Stroms zu detektieren, wenn das von der Messeinrichtung empfangene Signal von einem vorbestimmten Wertebereich abweicht, während die Prüfeinrichtung den ersten Eingangsanschluss der Messeinrichtung mit dem vorgegebenen Spannungspotential koppelt. Hierzu kann die Kontrolleinrichtung beispielsweise ein von der Messeinrichtung zu dem an dem ersten Eingangsanschluss anliegenden Signal korrespondierendes Ausgangssignal empfangen und dieses mit einem vorgegebenen Wertebereich vergleichen. Selbstverständlich kann der Vergleich des von der Messeinrichtung empfangenen Signals mit dem vorbestimmten Wertebereich auch auf beliebige weitere Weise erfolgen.

Ferner ist vorgesehen:
Ein Verfahren zur Diagnose von Sensorsignalen eines erfassten mehrphasigen elektrischen Stroms, bei welchem die Sensorsignale an Eingangsanschlüssen einer Messeinrichtung bereitgestellt werden. Das Verfahren umfasst einen Schritt zum elektrischen Koppeln eines ersten Eingangsanschlusses der Messeinrichtung für eine vorbestimmte Zeitspanne mit einem vorgegebenen Spannungspotential. Weiterhin umfasst das Verfahren einen Schritt zum Bestimmen eines Wertes für ein an dem ersten Eingangsanschluss der Messeinrichtung anliegenden Signales, sowie einen Schritt zum Detektieren einer Fehlfunktion bei der Erfassung des mehrphasig elektrischen Stroms, wenn während des Koppelns des ersten Eingangsanschlusses mit dem vorgegebenen Spannungspotential der Wert des Signals an dem ersten Eingangsanschluss von einem vorbestimmten Wertebereich abweicht.

### Vorteile der Erfindung

Der vorliegenden Erfindung liegt die Erkenntnis zugrunde, dass der korrekten Erfassung von Phasenströmen beispielsweise bei der Regelung von elektrischen Antriebssystemen oder gegebenenfalls auch weiteren mehrphasigen elektrischen Systemen eine große Bedeutung zukommt. Aufgrund von Alterung, fehlerhaften Referenzspannungen oder zahlreichen weiteren Fehlern kann es bei der Erfassung der Phasenströme zu Ungenauigkeiten oder Fehlern kommen. Fehlerhaft oder ungenau erfasste Stromwerte können jedoch zu Störungen und Instabilitäten bei der Regelung eines elektrischen Systems führen.

Der vorliegenden Erfindung liegt daher die Idee zugrunde, dieser Erkenntnis Rechnung zu tragen und eine Diagnose bei der Erfassung von Phasenströmen eines mehrphasigen elektrischen Systems vorzusehen. Dabei berücksichtigt die vorliegende Erfindung insbesondere, dass bei einer vollständigen Erfassung aller Phasenströme eines mehrphasigen elektrischen Systems aufgrund der Kirchhoff'schen Regel ein solches System überbestimmt ist. Daher kann das Sensorsignal eines Stromsensors von einer Phase jeweils kurzzeitig mit einem vorgegebenen Spannungspotential gekoppelt werden und somit bewusst ein signifikant abweichender Wert eingestellt werden. Diese bewusst eingestellte Abweichung kann daraufhin detektiert werden, um somit auf eine korrekte Funktion in dem Pfad der Erfassung des jeweiligen Phasenstroms zu schließen. Wird dabei während der Kopplung eines entsprechenden Messeingangs mit einem vorgegebenen Spannungspotential eine adäquate Abweichung des entsprechenden Wertes in dem Signalpfad detektiert, so kann von einer korrekten Funktion ausgegangen werden. Andernfalls ist dies ein Hinweis auf eine Störung bei der Erfassung der Phasenströme.

Der jeweilige aktuelle Phasenstrom für diejenige Phase, deren Signalpfad mit dem vorgegebenen Spannungspotential gekoppelt wird, kann dabei aufgrund der Kirchhoff'schen Regel aus den übrigen Phasenströmen berechnet werden. Somit stehen auch während der Überprüfung der messtechnischen Erfassung eines Phasenstroms die Informationen über alle Phasenströme weiterhin zur Verfügung. Daher kann die Diagnose der Erfassung der Phasenströme während des laufenden Betriebs erfolgen, ohne dass es hierbei zu einer Beeinträchtigung des Gesamtsystems kommt.

Gemäß einer Ausführungsform ist die Messeinrichtung dazu ausgelegt, einen Wert für den elektrischen Phasenstrom zu berechnen, dessen korrespondierendes Sensorsignal an dem ersten Eingangsanschluss bereitgestellt wird. Da jeweils nur ein Eingangsanschluss der Messeinrichtung mit einem vorgegebenen Spannungspotential gekoppelt wird, kann aus den verbleibenden Werten der Phasenströme der Wert des Phasenstroms berechnet werden, dessen Eingangsanschluss aktuell überprüft wird. Somit stehen stets die Werte aller Phasenströme zur Verfügung.

Gemäß der Erfindung ist die Prüfeinrichtung dazu ausgelegt, die vorbestimmte Zeitspanne für das Koppeln des Eingangsanschlusses der Messeinrichtung mit einem Spannungspotential in Abhängigkeit von einer Periodendauer des mehrphasigen elektrischen Stroms anzupassen. insbesondere kann das Koppeln eines Eingangsanschlusses der Messeinrichtung mit einem vorgegebenen Spannungspotential dabei für einen vorgegebenen Teil der Periodendauer des mehrphasigen elektrischen Stroms eingestellt werden. Beispielsweise kann bei einem dreiphasigen System ein Eingangsanschluss der Messeinrichtung für ein Drittel oder ein Sechstel einer Periodendauer mit dem vorbestimmten Spannungspotential gekoppelt werden.

Gemäß einer Ausführungsform umfasst die Messeinrichtung einen Ausgabeanschluss, der dazu ausgelegt ist, ein vorgegebenes Spannungspotential bereitzustellen. Dieser Ausgabeanschluss kann mit dem ersten Eingangsanschluss der Messeinrichtung elektrisch gekoppelt sein. Auf diese Weise kann durch Einstellen des vorgegebenen Spannungspotentials an dem Ausgabeanschluss der erste Eingangsanschluss der Messeinrichtung mit dem entsprechenden Spannungspotential gekoppelt werden. Beispielsweise kann es sich bei der Messeinrichtung um einen integrierten Schaltkreis, wie zum Beispiel einen Mikrocontroller oder ähnliches, handeln, welcher neben Signaleingängen auch einen oder mehrere Anschlüsse aufweist, die als Ausgänge geschaltet werden können.

Gemäß einer Ausführungsform ist die Prüfeinrichtung dazu ausgelegt, jeweils einen Eingangsanschluss der Messeinrichtung für eine vorbestimmte Zeitspanne mit einem vorgegebenen Spannungspotential zu koppeln. Hierbei kann die Kontrolleinrichtung dazu ausgelegt sein, eine Fehlfunktion der Erfassung des mehrphasigen elektrischen Stroms zu detektieren, wenn das von der Messeinrichtung empfangene Signal von einem vorbestimmten Wertebereich abweicht, während die Prüfeinrichtung den jeweiligen Eingangsanschluss der Messeinrichtung mit dem vorgegebenen Spannungspotential koppelt. Auf diese Weise können nacheinander alle Eingangsanschlüsse der Messeinrichtung und die damit korrespondierenden Signalpfade überprüft werden.

Gemäß einer Ausführungsform ist die Prüfeinrichtung dazu ausgelegt, während einer Periodendauer des mehrphasigen elektrischen Stroms jeden Eingangsanschluss der Messeinrichtung für eine vorbestimmte Zeitdauer mit dem vorgegebenen Spannungspotential zu koppeln. Auf diese Weise können alle Eingangsanschlüsse der Messeinrichtung zuverlässig überprüft werden.

Gemäß einer Ausführungsform koppelt die Messeinrichtung jeweils maximal einen Eingangsanschluss der Messeinrichtung mit dem vorgegebenen Spannungspotential. Auf diese Weise kann sichergestellt sein, dass auch während der Überprüfung der Eingangsanschlüsse der Messeinrichtung und der entsprechenden Signalpfade stets alle Werte der Phasenströme ermittelt werden können.

Gemäß einer Ausführungsform umfasst das vorbestimmte Spannungspotential ein Bezugspotential. Ferner kann das vorbestimmte Potential auch zusätzlich oder alternativ ein von einem Bezugspotential abweichendes festes Spannungspotential umfassen. Die Kopplung zwischen dem vorbestimmten Spannungspotential und dem Eingangsanschluss der Messeinrichtung kann dabei insbesondere über einen elektrischen Widerstand erfolgen. Wird der jeweilige Eingangsanschluss der Messeinrichtung gleichzeitig jeweils über einen Widerstand mit dem Bezugspotential und einem davon abweichenden festen Spannungspotential gekoppelt, so ergibt sich daraus ein Spannungsteiler. Mittels eines Spannungsteilers kann dabei in einem breiten Spektrum ein gewünschter Spannungswert an dem jeweiligen Eingangsanschluss der Messeinrichtung eingestellt werden.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann dabei auch Einzelaspekte als Verbesserungen oder Ergänzungen zu den jeweiligen Grundformen der Erfindung hinzufügen.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- Figur 1:: eine schematische Darstellung eines mehrphasigen elektrischen Antriebssystems mit einer Vorrichtung zur Diagnose der Erfassung eines mehrphasigen elektrischen Stromes gemäß einer Ausführungsform;
- Figur 2:: eine schematische Darstellung einer Vorrichtung zur Diagnose einer Erfassung eines mehrphasigen elektrischen Stroms gemäß einer Ausführungsform;
- Figur 3:: ein Spannungs-Zeitdiagramm für den Verlauf eines mehrphasigen elektrischen Stroms;
- Figur 4:: eine schematische Darstellung eines Signalverlaufs von Steuersignalen in einer Vorrichtung zur Diagnose der Erfassung eines mehrphasigen elektrischen Stroms gemäß einer Ausführungsform; und
- Figur 5:: eine schematische Darstellung eines Ablaufdiagramms, wie es einem Verfahren zur Diagnose von Sensorsignalen eines erfassten mehrphasigen elektrischen Stroms zugrunde liegt.

### Ausführungsformen der Erfindung

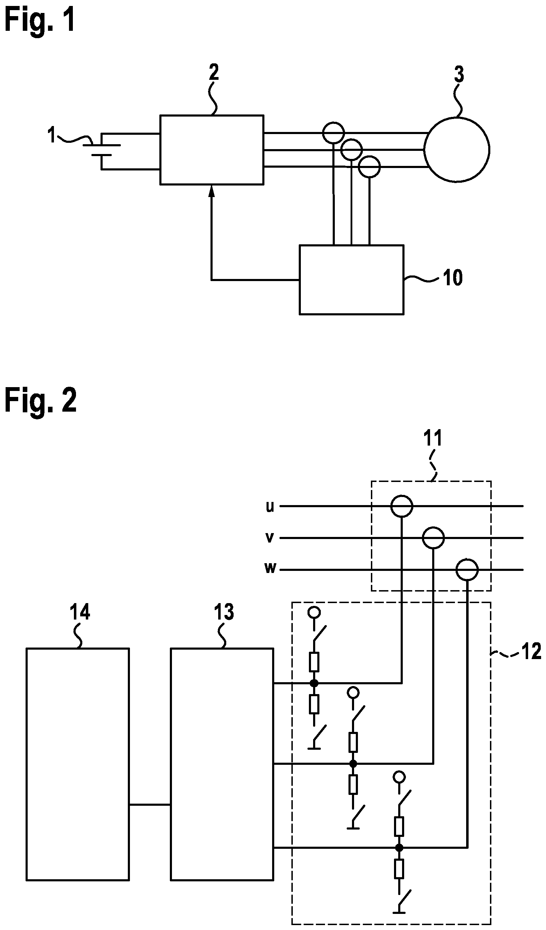

Figur 1 zeigt eine schematische Darstellung eines elektrischen Antriebssystems mit einer Vorrichtung 10 zur Diagnose einer Erfassung eines mehrphasigen elektrischen Stroms. Das elektrische Antriebssystem umfasst eine mehrphasige elektrische Maschine 3. Diese mehrphasige elektrische Maschine 3 wird von einem elektrischen Stromrichter 2 gespeist. Der elektrische Stromrichter 2 kann dabei seine elektrische Energie beispielsweise von einer Gleichspannungsquelle 1 beziehen. Bei der Gleichspannungsquelle 1 kann es sich beispielsweise um die Traktionsbatterie eines Elektro- oder Hybridfahrzeugs handeln. Auf diese Weise kann ein elektrischer Antrieb für ein solches Elektro- oder Hybridfahrzeug realisiert werden. Soll in der elektrischen Maschine 3 ein vorgegebenes Drehmoment eingestellt werden, so können hierzu beispielsweise mittels geeigneter Stromsensoren die Phasenströme in den Phasen zwischen dem Stromrichter 2 und der elektrischen Maschine 3 erfasst werden. Diese Phasenströme können von einer Steuervorrichtung 4 ausgewertet werden. Basierend auf der Auswertung der Phasenströme und einem vorgegebenen Drehmoment kann die Steuervorrichtung 4 geeignete Steuersignale für den Stromrichter 2 generieren, um in der elektrischen Maschine 3 den vorgegebenen Sollwert einzustellen.

Um eine Fehlfunktion, insbesondere ein ungewolltes Beschleunigen oder Abbremsen der elektrischen Maschine 3 zu verhindern, können hierbei die erfassten Phasenströme verifiziert werden. Wird dabei ein Fehler bei der Erfassung der Phasenströme detektiert, so kann gegebenenfalls die Regelung des elektrischen Antriebssystems eingestellt werden, um größere Schäden aufgrund einer Fehlfunktion zu verhindern. Gegebenenfalls kann es bei der Verifikation der erfassten Phasenströme auch möglich sein, eine Abweichung zwischen einer ermittelten Größe der erfassten Phasenströme und einem tatsächlichen Wert der erfassten Phasenströme zu bestimmen. Basierend auf dieser Abweichung kann gegebenenfalls ein Korrekturfaktor oder eine Korrekturfunktion ermittelt werden. Unter Verwendung dieses Korrekturfaktors oder dieser Korrekturfunktion kann die Steuervorrichtung 4 daraufhin die tatsächlichen Phasenströme berechnen. Basierend auf diesen korrigierten tatsächlichen Phasenströmen kann eine weitere Regelung des elektrischen Antriebssystems erfolgen.

Figur 2 zeigt eine schematische Darstellung einer Vorrichtung 10 zur Diagnose einer Erfassung eines mehrphasigen elektrischen Stroms gemäß einer Ausführungsform. Die Vorrichtung 10 umfasst einen Stromsensor 11, eine Prüfeinrichtung 12, eine Messeinrichtung 13 und eine Kontrolleinrichtung 14. Der Stromsensor 11 erfasst die elektrischen Phasenströme in den Phasen U, V und W. Hierzu kann der Stromsensor 11 beispielsweise für jede Phase U, V, W ein Sensorelement umfassen, welches ein zu dem in der jeweiligen Phase U, V, W fließenden elektrischen Stroms korrespondierendes Signal bereitstellt. Das Ausgangssignal jedes Sensorelements des Stromsensors 11 kann jeweils mit einem Eingang der Messeinrichtung 13 verbunden werden. Beispielsweise kann jedes Sensorelement des Stromsensors 11 ein zu dem in der jeweiligen Phase U, V, W fließenden elektrischen Stroms korrespondierendes Spannungssignal ausgeben. Dieses Spannungssignal kann von dem entsprechenden Eingang der Messeinrichtung 13 erfasst und gegebenenfalls digitalisiert werden. Das so erfasste und gegebenenfalls digitalisierte Signal kann daraufhin für eine Weiterverarbeitung, insbesondere eine Regelung eines elektrischen Antriebssystems oder ähnliches weiter verwendet werden. Mittels der Prüfeinrichtung 12 können die Eingänge der Messeinrichtung 13 mit einem vorgegebenen Spannungspotential gekoppelt werden. Hierbei wird jeweils maximal ein Eingangsanschluss der Messeinrichtung 13 mit einem vorgegebenen Spannungspotential gekoppelt. Die Kopplung eines Eingangsanschlusses der Messeinrichtung 13 mit einem vorgegebenen Spannungspotential kann beispielsweise durch das Schließen eines Schaltelements erfolgen. Hierzu kann das entsprechende Schaltelement über einen elektrischen Widerstand mit dem entsprechenden Spannungspotential einerseits und dem jeweiligen Eingangsanschluss der Messeinrichtung 13 andererseits verbunden werden. Insbesondere ist es auch möglich, einen Spannungsteiler aus mindestens zwei elektrischen Widerständen zu bilden, wobei ein erster Widerstand über ein erstes Schaltelement mit einem ersten Spannungspotential, beispielsweise einem Bezugspotential verbunden ist, und ein weiterer elektrischer Widerstand über ein weiteres Schaltelement mit einem weiteren Spannungspotential, beispielsweise einem vom Bezugspotential verschiedenes Spannungspotential verbunden ist. Werden dabei beide Schaltelemente dieses Spannungsteilers geschlossen, so stellt sich am Knotenpunkt der beiden Widerstände, der mit dem Eingangsanschluss der Messeinrichtung 13 verbunden ist, ein entsprechender Spannungswert ein.

Anstelle eines Schaltelements in der Prüfeinrichtung 12 kann das Koppeln eines Eingangsanschluss der Messeinrichtung 13 mit einem Spannungspotential auch mittels eines Ausgabeanschluss eines integrierten Schaltkreises, insbesondere eines Ausgabeanschlusses der Messeinrichtung 13 erfolgen. Verfügt die Messeinrichtung 13 beispielsweise über einen oder mehrere Anschlüsse, die als Ausgabeanschluss geschaltet werden können, so können diese Ausgabeanschlüsse dazu verwendet werden, um ein vorgegebenes Spannungspotential auszugeben, um hiermit die entsprechenden Eingangsanschlüssen der Messeinrichtung 13 zu beaufschlagen.

Wird ein Eingangsanschluss der Prüfeinrichtung 12 auf eine der zuvor beschriebenen Weisen mit einem vorgegebenen Spannungspotential gekoppelt, so hat dies einen Einfluss auf den Wert der Spannung, die an dem entsprechenden Eingangsanschluss der Messeinrichtung 13 anliegt. Diese entsprechende Änderung des Spannungswerts an dem jeweiligen Eingangsanschluss der Messeinrichtung 13 kann von der Kontrolleinrichtung 14 detektiert werden. Wird von der Kontrolleinrichtung 14 festgestellt, dass beim Verbinden des entsprechenden Eingangsanschlusses der Messeinrichtung 13 mit dem vorgegebenen Spannungspotential durch die Messeinrichtung 13 ein Wert erfasst wird, der einem vorgegebenen zu erwartenden Wertebereich entspricht, so kann hieraus auf eine korrekte Funktion der Messeinrichtung geschlossen werden. Kann bei einer Kopplung des Eingangsanschlusses der Messeinrichtung 13 mit dem vorgegebenen Spannungspotential jedoch durch die Kontrolleinrichtung 14 kein Wert detektiert werden, der einem vorgegebenen zu erwartenden Wertebereich entspricht, so ist dies ein Hinweis auf eine Fehlfunktion. Dies kann beispielsweise auf einen Fehler innerhalb der Messeinrichtung 13 oder auch außerhalb der Messeinrichtung 13 hinweisen.

Für die beschriebene Überprüfung kann die Spannung an den Eingangsanschlüssen der Messeinrichtung 13 auf einen Wert eingestellt werden, der außerhalb eines Wertebereichs liegt, wie er beim regulären Betrieb zur Erfassung der Phasenströme auftritt. Hierdurch kann schnell zwischen den regulären Messwerten und den Prüfwerten während der Kopplung mit dem vorgegebenen Spannungspotential unterschieden werden. Alternativ ist es auch möglich, durch entsprechende Wahl des vorgegebenen Spannungspotentials und/oder der Widerstände zwischen Spannungspotential und Eingangsanschluss der Messeinrichtung 13 während der Kopplung einen Spannungswert einzustellen, der innerhalb des regulären Wertebereichs liegt, wie er auch während der Erfassung der Phasenströme auftritt.

Wird durch das Koppeln eines Eingangs der Messeinrichtung 13 mit einem vorgegebenen Spannungspotential der entsprechende Eingang der Messeinrichtung 13 auf eine bekannte Spannung eingestellt, so kann die Kontrolleinrichtung 14 den von der Messeinrichtung 13 erfassten Wert mit dem bekannten am entsprechenden Eingang anliegenden Wert vergleichen. Gegebenenfalls kann hieraus ein Korrekturfaktor oder eine Korrekturfunktion berechnet werden, um eventuell auftretende Alterungseffekte oder ähnliches in der Messeinrichtung 13 zu kompensieren.

Während ein Eingangsanschluss der Messeinrichtung 13 durch die Prüfeinrichtung 12 mit einem vorgegebenen Spannungspotential gekoppelt wird, kann der Wert eines elektrischen Stroms für die Phase, die durch den entsprechenden Eingang der Messeinrichtung 13 überwacht werden soll, aus den Werten der übrigen Phasen berechnet werden. Aufgrund der Kirchhoff'schen Regel ergibt die Summe aller Phasenströme stets Null. Auf diese Weise können somit sehr einfach alle Phasenströme bestimmt werden, selbst wenn ein Messeingang kurzzeitig durch die Prüfeinrichtung auf einen abweichenden Wert eingestellt wird.

Die Zeitspanne, in der die Prüfeinrichtung 12 einen Eingang der Messeinrichtung 13 mit einem vorgegebenen Spannungspotential koppelt, entspricht dabei in der Regel einem Bruchteil der Periodendauer einer Wechselspannung des zu erfassenden mehrphasigen Stroms. Bei einem n-phasigen elektrischen System kann ein Eingang der Messeinrichtung 13 dabei jeweils für die Zeitdauer von T/n oder T / (2 x n) mit dem vorgegebenen Spannungswert gekoppelt werden, während für die restliche Zeit der entsprechende Eingang jeweils ausschließlich mit dem entsprechenden Element des Stromsensors 11 verbunden ist. Dabei ist T die Periodendauer des mehrphasigen elektrischen Stroms.

Die Prüfeinrichtung 12 kann beispielsweise abwechselnd alle Eingangsanschlüsse der Messeinrichtung 13, die mit einem Sensorelement des Stromsensors 11 gekoppelt sind, mit einem vorgegebenen Spannungspotential koppeln. Dabei wird jedoch maximal stets ein Eingang der Messeinrichtung 13 mit dem vorgegebenen Spannungspotential gekoppelt, während die restlichen Eingänge unbeeinflusst mit den entsprechenden Sensorelementen verbunden sind. Auf diese Weise kann aufgrund der oben beschriebenen Kirchhoff'schen Regel stets der korrekte Wert aller Phasenströme bestimmt werden.

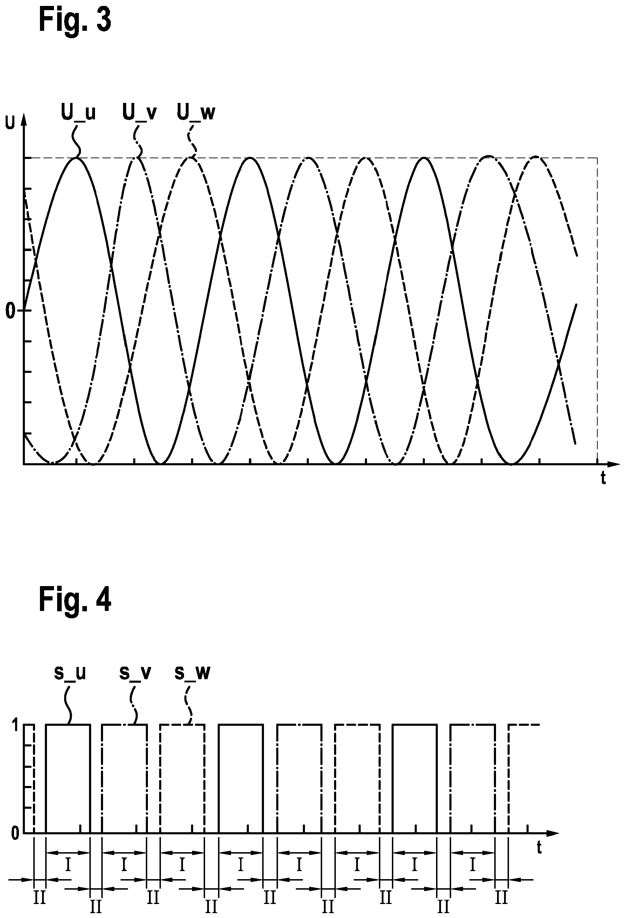

Figur 3 zeigt eine schematische Darstellung des Verlaufs der elektrischen Ströme U_u,U_v und U_w in einem mehrphasigen elektrischen System mit drei Phasen. Die Ströme zwischen den einzelnen Phasen sind dabei jeweils um 120° phasenversetzt. Dabei gibt die Summe aller Ströme in allen Phasen zusammen jeweils 0 A. Aus diesem Grund kann der Wert des elektrischen Stroms einer Phase auch stets aus den verbleibenden zwei Phasen berechnet werden.

Figur 4 zeigt eine schematische Darstellung für die Ansteuerungssignale s_u, s_v und s_w der Schaltelemente zur Kopplung der Eingangsanschlüsse der Messeinrichtung 13 mit einem vorgegebenen Spannungspotential. Wie dabei zu erkennen ist, wird jeweils maximal ein Eingangsanschluss der Messeinrichtung 13 mit dem vorgegebenen Spannungspotential gekoppelt, während alle verbleibenden Eingangsanschlüsse jeweils die Ausgangssignale der entsprechenden Sensorelemente des Stromsensors 11 erfassen können. Dabei wird in jeder Periode des Phasenstroms jeweils für eine vorgegebene Zeitspanne ein Eingangsanschluss der Messeinrichtung 13 mit dem vorgegebenen Spannungspotential gekoppelt. Dieser Ablauf kann sich, wie hier dargestellt, in jeder Periode wiederholen. Es ist jedoch auch möglich, dass die Überprüfung nicht in jeder Periode ausgeführt wird, sondern beispielsweise auch eine oder mehrere Periode ohne eine Überprüfung folgen können.

In dem in Abbildung 4 dargestellten Verlauf existieren dabei Zeiträume I, in denen ein Eingangsanschluss der Messeinrichtung 13 mit einem Spannungspotential gekoppelt ist. Weiterhin existieren auch Zeiträume II, in denen kein Eingangsanschluss 13 mit einem Spannungspotential gekoppelt ist, sondern alle Eingangsanschlüsse nur mit den entsprechenden Sensorelementen des Stromsensors 11 verbunden sind und somit eine vollständige Erfassung aller Phasenströme erfolgt. Auf diese Weise kann ein Multiplexbetrieb realisiert werden. In diesem Multiplexbetrieb werden in einem ersten Zeitabschnitt alle elektrischen Ströme basierend auf den Sensorsignalen aller Sensorelemente des Stromsensors 11 ermittelt. Hierbei kann mittels der Kirchhoff'schen Regel überprüft werden, ob die Sensorsignale plausibel sind, d.h. dass die Summe aller elektrischen Ströme Null ergibt. in einem weiteren Zeitabschnitt kann jeweils ein Eingangsanschluss 13 mit einem Spanungspotential gekoppelt werden. Hierdurch kann der jeweilige Signalpfad überprüft werden. In dem Multiplexbetrieb wechseln sich dabei die Vorgänge der beiden zuvor beschriebenen Zeitabschnitte ab.

Die vorausgegangenen Ausführungen sind im Zusammenhang mit einem dreiphasigen elektrischen System beschrieben. Darüber hinaus lässt sich das erfindungsgemäße Prinzip jedoch auf eine beliebige Anzahl von mehr als drei Phasen erweitern.

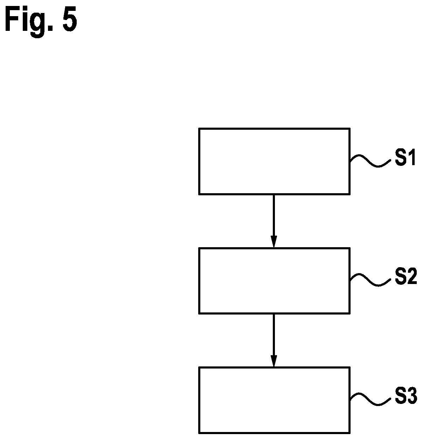

Figur 5 zeigt eine schematische Darstellung eines Ablaufdiagramms, wie es einem Verfahren zur Diagnose von Sensorsignalen eines erfassten mehrphasigen elektrischen Stroms zugrunde liegt. Die zu diagnostizierenden Sensorsignale werden dabei an Eingangsanschlüssen einer Messeinrichtung 13 bereitgestellt. Das Verfahren umfasst einen Schritt zum elektrischen Koppeln eines Eingangsanschlusses der Messeinrichtung 13 mit einem vorgegebenen Spannungspotential. Die Kopplung mit dem vorgegebenen Spannungspotential kann dabei insbesondere für eine vorbestimmte Zeitspanne erfolgen. In Schritt S2 wird daraufhin ein Wert des an dem entsprechenden Eingang der Messeinrichtung anliegenden Signals bestimmt. Anschließend wird in Schritt S3 eine Fehlfunktion bei der Erfassung des mehrphasigen elektrischen Stroms detektiert, wenn während des Koppelns des Eingangsanschlusses mit dem vorgegebenen Spannungspotential der Wert des Signals an dem Eingangsanschluss von einem vorbestimmten Wertebereich abweicht. Wird eine solche Fehlfunktion detektiert, so kann gegebenenfalls ein Korrekturfaktor oder eine Korrekturfunktion ermittelt werden, um einen von der Messeinrichtung ermittelten Wert für ein an dem entsprechenden Eingangsanschluss anliegendes Signal mittels des Korrekturfaktors oder der Korrekturfunktion anzupassen. Die Ermittlung der Korrekturfunktion bzw. des Korrekturwerts kann dabei unter Kenntnis des bekannten vorgegebenen Spannungspotentials am Eingangsanschluss der Messeinrichtung 13 erfolgen.

Zusammenfassend betrifft die vorliegende Erfindung die Überprüfung von Stromsensorsignalen eines mehrphasigen elektrischen Systems. Hierzu werden die Signalpfade zwischen einem Stromsensorelement und einer Messeinrichtung kurzzeitig mit einem vorgegebenen elektrischen Potential gekoppelt. Daraufhin kann eine Änderung in der nachgeschalteten Messwerterfassung ausgewertet werden, um auf eine eventuelle Fehlfunktion während der Erfassung zu schließen.

## Patentansprüche

1. Vorrichtung zur Diagnose einer Erfassung eines mehrphasigen elektrischen Stroms, mit:
einem Stromsensor (11), der dazu ausgelegt ist, elektrische Phasenströme in den Phasen des zu erfassenden mehrphasigen elektrischen Stroms zu messen und zu den gemessenen Phasenströmen korrespondierende Sensorsignale an Ausgangsanschlüssen bereitzustellen;
eine Messeinrichtung (13), mit mehreren Eingangsanschlüssen, wobei jeweils ein Eingangsanschluss mit einem Ausgangsanschluss des Stromsensors (11) elektrisch gekoppelt ist, und wobei die Messeinrichtung (13) dazu ausgelegt ist, an den Eingangsanschlüssen bereitgestellte Signale zu erfassen;
einer Prüfeinrichtung (12), die mit einem ersten Eingangsanschluss der Eingangsanschlüsse der Messeinrichtung (13) elektrisch gekoppelt ist und die dazu ausgelegt ist, den ersten Eingangsanschluss der Messeinrichtung (13) für eine vorbestimmte Zeitspanne mit einem vorgegebenen Spannungspotential zu koppeln; und
einer Kontrolleinrichtung (14), die dazu ausgelegt ist, eine Fehlfunktion bei der Erfassung des mehrphasigen elektrischen Stroms detektieren, wenn das von der Messeinrichtung (13) empfangene Signal von einem vorbestimmten Wertebereich abweicht, während die Prüfeinrichtung (12) den ersten Eingangsanschluss der Messeinrichtung (13) mit dem vorgegebenen Spannungspotential koppelt,
**dadurch gekennzeichnet, dass**
die Prüfeinrichtung (12) dazu ausgelegt ist, die vorbestimmte Zeitspanne für das Koppeln des ersten Eingangsanschlusses der Messeinrichtung (13) mit einem Spannungspotential in Abhängigkeit von einer Periodendauer des mehrphasigen elektrischen Stroms anzupassen.

2. Vorrichtung nach Anspruch 1, wobei die Messeinrichtung (13) dazu ausgelegt ist, einen Wert für den elektrischen Phasenstrom zu berechnen, dessen korrespondierendes Sensorsignal an dem ersten Eingangsanschluss bereitgestellt wird.

3. Vorrichtung nach einem der Ansprüche 1 bis 2, wobei die Messeinrichtung (13) einen Ausgabeanschluss umfasst, der mit dem ersten Eingangsanschluss der Messeinrichtung (13) elektrisch gekoppelt ist, wobei die Messeinrichtung (13) dazu ausgelegt ist, an dem Ausgabeanschluss ein vorbestimmtes Spannungspotential einzustellen.

4. Vorrichtung nach einem der Ansprüche 1 bis 3, wobei die Prüfeinrichtung dazu ausgelegt ist, jeweils einen Eingangsanschluss der Messeinrichtung (13) für eine vorbestimmte Zeitspanne mit einem vorgegebenen Spannungspotential zu koppeln; und wobei die Kontrolleinrichtung (14) dazu ausgelegt ist, eine Fehlfunktion der Erfassung des mehrphasigen elektrischen Stroms detektieren, wenn das von der Messeinrichtung (13) empfangene Signal von einem vorbestimmten Wertebereich abweicht, während die Prüfeinrichtung (12) den jeweiligen Eingangsanschluss der Messeinrichtung mit dem vorgegebenen Spannungspotential koppelt.

5. Vorrichtung nach Anspruch 4, wobei die Prüfeinrichtung (12) dazu ausgelegt ist, während einer Periodendauer des mehrphasigen elektrischen Stroms jeden Eingangsanschluss der Messeinrichtung (13) für eine vorbestimmte Zeitdauer mit dem vorgegebenen Spannungspotential zu koppeln.

6. Vorrichtung nach Anspruch 5, wobei die Messeinrichtung (13) jeweils maximal einen Eingangsanschluss der Messeinrichtung (13) mit dem vorgegebenen Spannungspotential koppelt.

7. Vorrichtung nach einem der Ansprüche 1 bis 6, wobei das vorbestimmte Spannungspotential ein Bezugspotential und/oder ein von dem Bezugspotential abweichendes festes Spannungspotential umfasst.

8. Verfahren zur Diagnose von Sensorsignalen eines erfassten mehrphasigen elektrischen Stroms, die an Eingangsanschlüssen einer Messeinrichtung (13) bereitgestellt werden, mit den Schritten:
elektrisches Koppeln (S1) eines ersten Eingangsanschlusses der Messeinrichtung (13) für eine vorbestimmte Zeitspanne mit einem vorgegebenen Spannungspotential;
Bestimmen (S2) eines Werts für ein an dem ersten Eingangsanschluss der Messeinrichtung (13) anliegenden Signals;
Detektieren (S3) einer Fehlfunktion bei der Erfassung des mehrphasigen elektrischen Stroms, wenn während des Koppelns des ersten Eingangsanschlusses mit dem vorgegebenen Spannungspotential der Wert des Signals an dem ersten Eingangsanschluss von einem vorbestimmten Wertebereich abweicht,
**dadurch gekennzeichnet, dass**
die vorbestimmte Zeitspanne für das Koppeln des ersten Eingangsanschlusses der Messeinrichtung (13) mit einem Spannungspotential in Abhängigkeit von einer Periodendauer des mehrphasigen elektrischen Stroms angepasst wird.

## Claims

1. Device for diagnosing a detection of a polyphase electric current, comprising:
a current sensor (11) designed to measure electric phase currents in the phases of the polyphase electric current to be detected and to provide sensor signals corresponding to the measured phase currents at output terminals;
a measuring unit (13), comprising a plurality of input terminals, wherein an input terminal is respectively electrically coupled to an output terminal of the current sensor (11), and wherein
the measuring unit (13) is designed to detect signals provided at the input terminals;
a test unit (12), which is electrically coupled to a first input terminal of the input terminals of the measuring unit (13) and which is designed to couple the first input terminal of the measuring unit (13) to a predefined voltage potential for a predetermined time period; and
a monitoring unit (14) designed to detect a malfunction during the detection of the polyphase electric current if the signal received by the measuring unit (13) deviates from a predetermined value range while the test unit (12) couples the first input terminal of the measuring unit (13) to the predefined voltage potential,
**characterized in that**
the test unit (12) is designed to adapt the predetermined time period for coupling the first input terminal of the measuring unit (13) to a voltage potential depending on a period duration of the polyphase electric current.

2. Device according to Claim 1, wherein the measuring unit (13) is designed to calculate a value for the electric phase current whose corresponding sensor signal is provided at the first input terminal.

3. Device according to either of Claims 1 and 2, wherein the measuring unit (13) comprises an output terminal electrically coupled to the first input terminal of the measuring unit (13), wherein the measuring unit (13) is designed to set a predetermined voltage potential at the output terminal.

4. Device according to any of Claims 1 to 3, wherein the test unit is designed to couple a respective input terminal of the measuring unit (13) to a predefined voltage potential for a predetermined time period; and wherein the monitoring unit (14) is designed to detect a malfunction of the detection of the polyphase electric current if the signal received by the measuring unit (13) deviates from a predetermined value range while the test unit (12) couples the respective input terminal of the measuring unit to the predefined voltage potential.

5. Device according to Claim 4, wherein the test unit (12) is designed so as, during a period duration of the polyphase electric current, to couple each input terminal of the measuring unit (13) to the predefined voltage potential for a predetermined time period.

6. Device according to Claim 5, wherein the measuring unit (13) couples in each case a maximum of one input terminal of the measuring unit (13) to the predefined voltage potential.

7. Device according to any of Claims 1 to 6, wherein the predetermined voltage potential comprises a reference potential and/or a fixed voltage potential deviating from the reference potential.

8. Method for diagnosing sensor signals of a detected polyphase electric current that are provided at input terminals of a measuring unit (13), comprising the steps of:
electrically coupling (S1) a first input terminal of the measuring unit (13) to a predefined voltage potential for a predetermined time period;
determining (S2) a value for a signal present at the first input terminal of the measuring unit (13) ;
detecting (S3) a malfunction during the detection of the polyphase electric current if, during the coupling of the first input terminal to the predefined voltage potential, the value of the signal at the first input terminal deviates from a predetermined value range,
**characterized in that**
the predetermined time period for coupling the first input terminal of the measuring unit (13) to a voltage potential is adapted depending on a period duration of the polyphase electric current.

## Revendications

1. Dispositif de diagnostic d'une détection d'un courant électrique polyphasé, comprenant :
un capteur de courant (11) qui est conçu pour mesurer des courants de phase électriques dans les phase du courant électrique polyphasé à détecter, et pour fournir au niveau de bornes de sortie des signaux de capteur correspondant aux courants de phase mesurés ;
un dispositif de mesure (13) pourvu de plusieurs bornes d'entrée, dans lequel respectivement une borne d'entrée est couplée électriquement à une borne de sortie du capteur de courant (11), et dans lequel le dispositif de mesure (13) est conçu pour détecter des signaux fournis aux bornes d'entrée ;
un dispositif de vérification (12) qui est couplé électriquement à une première borne d'entrée des bornes d'entrée du dispositif de mesure (13), et qui est conçu pour coupler pendant un laps de temps prédéterminé la première borne d'entrée du dispositif de mesure (13) à un potentiel de tension prédéfini ; et
un dispositif de contrôle (14) qui est conçu pour détecter un dysfonctionnement lors de la détection du courant électrique polyphasé si le signal reçu du dispositif de mesure (13) s'écarte d'une plage de valeurs prédéterminée pendant que le dispositif de vérification (12) couple la première borne d'entrée du dispositif de mesure (13) au potentiel de tension prédéfini,
**caractérisé en ce que** le dispositif de vérification (12) est conçu pour adapter le laps de temps prédéterminé pour le couplage de la première borne d'entrée du dispositif de mesure (13) à un potentiel de tension en fonction d'une durée de période du courant électrique polyphasé.

2. Dispositif selon la revendication 1, dans lequel le dispositif de mesure (13) est conçu pour calculer une valeur pour le courant de phase électrique dont le signal de capteur correspondant est fourni au niveau de la première borne d'entrée.

3. Dispositif selon l'une quelconque des revendications 1 à 2, dans lequel le dispositif de mesure (13) comprend une borne de sortie qui est couplée électriquement à la première borne d'entrée du dispositif de mesure (13), le dispositif de mesure (13) étant conçu pour régler un potentiel de tension prédéterminé au niveau de la borne de sortie.

4. Dispositif selon l'une quelconque des revendications 1 à 3, dans lequel le dispositif de vérification est conçu pour coupler respectivement une borne d'entrée du dispositif de mesure (13) pendant un laps de temps prédéterminé à un potentiel de tension prédéfini ; et dans lequel le dispositif de contrôle (14) est conçu pour détecter un dysfonctionnement de la détection du courant électrique polyphasé si le signal reçu du dispositif de mesure (13) s'écarte d'une plage de valeurs prédéterminée pendant que le dispositif de vérification (12) couple la borne d'entrée respective du dispositif de mesure au potentiel de tension prédéfini.

5. Dispositif selon la revendication 4, dans lequel le dispositif de vérification (12) est conçu pour coupler pendant une durée de période du courant électrique polyphasé chaque borne d'entrée du dispositif de mesure (13) au potentiel de tension prédéfini pendant une durée prédéterminée.

6. Dispositif selon la revendication 5, dans lequel le dispositif de mesure (13) couple respectivement au maximum une borne d'entrée du dispositif de mesure (13) au potentiel de tension prédéfini.

7. Dispositif selon l'une quelconque des revendications 1 à 6, dans lequel le potentiel de tension prédéterminé comprend un potentiel de référence et/ou un potentiel de tension fixe, différent du potentiel de référence.

8. Procédé de diagnostic de signaux de capteur d'un courant électrique polyphasé détecté qui sont fournis au niveau de bornes d'entrée d'un dispositif de mesure (13), comprenant les étapes consistant à :
coupler électriquement (S1) une première borne d'entrée du dispositif de mesure (13) à un potentiel de tension prédéfini, pendant un laps de temps prédéterminé ;
déterminer (S2) une valeur pour un signal appliqué à la première borne d'entrée du dispositif de mesure (13) ;
détecter (S3) un dysfonctionnement lors de la détection du courant électrique polyphasé si pendant le couplage de la première borne d'entrée au potentiel de tension prédéfini, la valeur du signal à la première borne d'entrée s'écarte d'une plage de valeurs prédéterminée,
**caractérisé en ce que** le laps de temps prédéterminé pour le couplage de la première borne d'entrée du dispositif de mesure (13) à un potentiel de tension est adapté en fonction d'une durée de période du courant électrique polyphasé.
